# EUROPEAN PATENT SPECIFICATION

(11) **EP 4 071 887 B1**
(45) Date of publication and mention of the grant of the patent: **01.04.2026**
(21) Application number: 21767104.9
(22) Date of filing: 08.02.2021
(51) Int. Cl.: H01M 10/48, H01M 50/116, H01M 50/543, H01M 50/557, H01M 10/613, H01M 10/647, H01M 10/653, H01M 10/655, H01M 10/6556, H01M 50/105, H01M 50/124, H01M 50/211

(54) **POUCH-SHAPED BATTERY HAVING SWELLING SENSING UNIT ADDED THERETO**
POUCH-BATTERIE MIT EINER REFLEKTIERENDEN FOLIE UND BATTERIEPACK MIT HINZUGEFÜGTER QUELLDETEKTIONSEINHEIT
BATTERIE DE TYPE SACHET COMPRENANT UN FILM RÉFLÉCHISSANT ET ENSEMBLE DE BATTERIES AYANT UNE UNITÉ DE DÉTECTION DE GONFLEMENT AJOUTÉE À CELLE-CI

(30) Priority: 09.03.2020 KR 20200028924
(43) Date of publication of application: 12.10.2022
(73) Proprietor: LG Energy Solution, Ltd., Seoul 07335 (KR)
(72) Inventor: SONG, Hyeon Jin, Daejeon 34122 (KR)
(74) Representative: Plasseraud IP
(86) International application number: PCT/KR2021/001666
(87) International publication number: WO 2021/182756

(56) References cited:
- JP-A- 2004 271 238
- JP-B2- 5 108 454
- KR-A- 20110 037 378
- KR-A- 20150 066 661
- KR-A- 20160 037 547
- KR-A- 20160 128 835
- KR-A- 20180 076 578
- KR-A- 20200 017 089
- KR-B1- 101 779 156

## Description

### [Technical Field]

The present invention relates to a pouch-shaped battery comprising a reflective film on a specific surface.

Further, the present invention relates to a pouch-shaped battery having a swelling sensing unit added thereto, wherein the swelling sensing unit is configured to easily sense swelling of the pouch-shaped battery due to overcharging, etc.

### [Background Art]

A lithium secondary battery is mainly classified as a cylindrical battery, a prismatic battery, or a pouch-shaped battery based on the external shape thereof, and is also classified as a lithium ion battery, a lithium ion polymer battery, a lithium polymer battery, or an all-solid-state battery based on the type of an electrolytic solution.

With miniaturization of mobile devices, demand for a pouch-shaped battery, which is easily deformed, is manufactured at low cost, and is lightweight, is high.

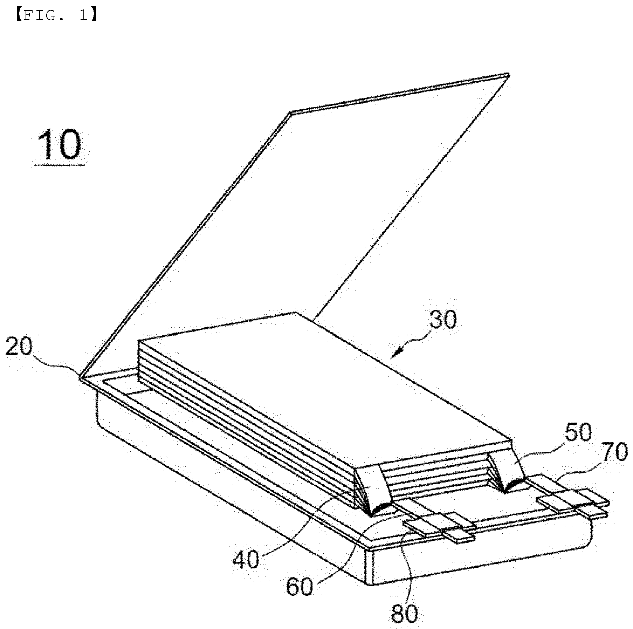

FIG. 1 is an exploded perspective view of a conventional general pouch-shaped battery. Referring to FIG. 1, the pouch-shaped battery 10 includes an electrode assembly 30, electrode tabs 40 and 50 extending from the electrode assembly 30, electrode leads 60 and 70 welded respectively to the electrode tabs 40 and 50, and a battery case 20 configured to receive the electrode assembly 30.

The electrode assembly 30 is a power-generating element configured such that a positive electrode and a negative electrode are sequentially stacked in the state in which a separator is interposed therebetween, and is configured to have a stacked type structure or a stacked/folded type structure. The electrode tabs 40 and 50 extend from respective electrode plates of the electrode assembly 30, and the electrode leads 60 and 70 are electrically connected respectively to the plurality of electrode tabs 40 and 50 extending from the respective electrode plates, for example, by welding, wherein a portion of each electrode lead is exposed outwards from the battery case 20. An insulative film 80 is attached to a portion of each of the upper and lower surfaces of each of the electrode leads 60 and 70 in order to improve the seal with the battery case 20 and at the same time to guarantee an electrically insulated state. The battery case 20 is made of an aluminum laminate sheet, provides a space capable of receiving the electrode assembly 30, and is generally formed so as to have a pouch shape.

The conventional pouch-shaped battery is not provided with a simple sensing unit configured to measure swelling of the battery due to overcharging, etc. In order to sense swelling of a battery, a strain gauge or a piezoelectric pressure sensor may be attached to the surface of the battery so as to sense a change in shape of the battery.

However, such a method has difficulty sensing overall swelling of the battery and is of no practical use. It is possible to sense only a change in shape of a specific region using the above method, and a plurality of sensors must be attached over a wide range of the battery in order to sense overall swelling of the battery. In the case in which the plurality of sensors is attached, a plurality of electrical lines, such as power lines configured to supply power to the sensors and sensing lines extending from the sensors, must also be connected. Recent batteries requiring high capacities have no spatial margins necessary to dispose such additional parts.

In many cases, the pouch-shaped battery is used as a part of a battery pack, although the pouch-shaped battery is also individually used. In this case, sensing swelling of the pouch-shaped battery may be important information necessary to determine whether the pouch-shaped battery is abnormal when considering a safety-related problem of the pouch-shaped battery (cell) disposed in the battery pack.

Therefore, it is necessary to introduce technology capable of sensing overall swelling of the pouch-shaped battery in order to macroscopically determine whether the battery (cell) is abnormal.

Also, in the case in which pouch-shaped batteries are stacked in the battery pack, it is necessary to efficiently transfer heat generated therein to the outside in order to cool the battery pack. However, technology capable of efficiently disposing a simple structure, configured to transfer such heat to the outside, in the battery pack has not been definitely suggested.

In Patent Document 1, the surface of a thin film configured to wrap a battery 8 is used as a reflective region, a light source 4 configured to emit light is provided at the inner surface of a detection cover configured to wrap the battery, reflected light is detected by a light detection region 5 formed in the inner surface of a detection cover in order to determine whether the battery swells. When the battery swells, light emitted by the light source 4 and reflected by the surface of the battery is changed, whereby the light detection region 5 senses such change. Patent Document 1 has a problem in that the reflective region is provided over the entire surface of the battery, whereby sensors must be widely disposed. Patent Document 1 is meaningful in the case in which it is necessary to sense the overall form in which the battery swells. However, a device for sensing swelling of the battery is too complicated and thus a wide space is needed to receive the device. Consequently, Patent Document 1 is not suitable for existing high-capacity batteries.

In Patent Document 2, optical fibers configured to reflect light are provided at the outer surface of a battery, light is irradiated through the optical fibers in order to measure the pressure of each battery module in a battery pack. In Patent Document 2, a method of measuring change in pressure using light is performed by a device in which a plurality of diffraction slits is disposed so as to be spaced apart from each other by a predetermined distance, when physical deformation occurs due to a change in pressure, the distance between the diffraction slits is changed, whereby a change in wavelength of light passing through the slits is measured to sense pressure.

Patent Document 3 discloses a swelling sensing method in the case in which a conductor configured to wrap an electrode assembly is cut by swelling. However, a separate current measurement device must be provided in a battery, safety of the battery may be adversely affected by the conductor, and there is a spatial limitation in providing a battery supply device and a detection device.

Patent Document 4 discloses technology for preventing swelling of a battery using a material configured to shrink when the temperature of the material increases.

Technology capable of sensing overall swelling of a pouch-shaped battery in order to macroscopically determine whether the battery (cell) is abnormal while overcoming such a spatial limitation and technology capable of efficiently disposing a simple structure, configured to efficiently transfer heat generated in pouch-shaped batteries to the outside in order to cool the pouch-shaped batteries in the case in which the pouch-shaped batteries are stacked in a battery pack, in a space defined in the battery pack have not yet been definitely suggested.

### (Prior Art Documents)

(Patent Document 1) Chinese Utility Model Publication No. 208013385 (2018.10.26)
(Patent Document 2) Japanese Patent Application Publication No. 2009-059582 (2009.03.19)
(Patent Document 3) Korean Patent Application Publication No. 2011-0037378 (2011.04.13)
(Patent Document 4) Korean Patent Application Publication No. 2014-0050182 (2014.04.29)
(Patent Document 5) KR20160037547A
(Patent Document 6) KR20180076578A
(Patent Document 7) KR20150066661A
(Patent Document 8) KR2004271238A

### [Disclosure]

### [Technical Problem]

The present invention has been made in view of the above problems, and objects of the present invention are to provide 1) technology capable of sensing overall swelling of a pouch-shaped battery in order to macroscopically determine whether the battery (cell) is abnormal while overcoming such a spatial limitation and 2) technology capable of efficiently disposing a simple structure, configured to efficiently transfer heat generated in pouch-shaped batteries to the outside in order to cool the pouch-shaped batteries in the case in which the pouch-shaped batteries are stacked in a battery pack, in a space defined in the battery pack.

### [Technical Solution]

In order to accomplish the above objects, the present invention provides a pouch-shaped battery having a lead protruding from at least one side surface thereof, wherein a reflective film is added to the one side surface, from which the lead protrudes. The reflective film may be a visible light reflective film.

A heat shrinkable film may be added so as to wrap the surface of the pouch-shaped battery, and a conductive film may be further added between the heat shrinkable film and the pouch-shaped battery. The conductive film may have at least one protrusion formed on the one side surface, from which the lead protrudes. Meanwhile, the heat shrinkable film or the conductive film may be integrated with the reflective film.

In order to sense swelling of the pouch-shaped battery, it is preferable for the reflective film to lack elasticity. In the case in which the pouch-shaped battery swells, the inelastic reflective film must be torn or cut. It is preferable that the reflective film be made of a material that has no danger of fire even in the case in which the temperature of a battery cell is high while being capable of being easily damaged by tensile strength, such as film or paper.

A battery pack including at least one pouch-shaped battery according to the present invention has a swelling sensing unit added thereto, wherein the swelling sensing unit includes a light irradiation portion and a sensor configured to sense tear or cutting of the reflective film.

The battery pack may further include at least one cooling portion disposed in contact with the protrusion.

A method of sensing swelling of the pouch-shaped battery in the battery pack according to the present invention includes:
a) irradiating, by the light irradiation portion, the reflective film of a target pouch-shaped battery with light;
b) sensing, the sensor, light reflected by the reflective film; and
c) determining that the target pouch-shaped battery has swelled in a case in which the sensor does not sense light reflected by the reflective film.

When the pouch-shaped battery expands due to swelling, whereby the reflective film is torn, and therefore light reflected by the reflective film is not sensed, the pouch-shaped battery may be determined to have swelled.

The pouch-shaped battery may be disposed in the battery pack, and the light irradiation portion and the sensor may be disposed at a side surface of the battery pack.

The method may further include a step of wrapping the surface of the pouch-shaped battery with the conductive film, adding the reflective film to the one side surface, from which the lead protrudes, and wrapping the surface of the pouch-shaped battery with the heat shrinkable film before the pouch-shaped battery is disposed in the battery pack.

The present invention may be provided in the state in which an arbitrary combination of the invention is possible.

### [Description of Drawings]

FIG. 1 is an exploded perspective view showing a general structure of a conventional pouch-shaped battery.
FIG. 2 is a perspective view of a pouch-shaped battery according to an embodiment of the present invention.
FIG. 3 is a side sectional view of the pouch-shaped battery according to the embodiment of the present invention.
FIG. 4 is a perspective view of a battery pack according to an embodiment of the present invention.
FIG. 5 is an AA' sectional view of the battery pack according to the embodiment of the present invention.
FIG. 6 is a schematic view showing a swelling sensing method according to an embodiment of the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part in the specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, a preferred manufacturing example and embodiments will be presented together with the drawings in order to assist in understanding the present invention. These are provided in order to illustrate the present invention and do not limit the scope of the present invention.

Here, the present invention will be described in more detail.

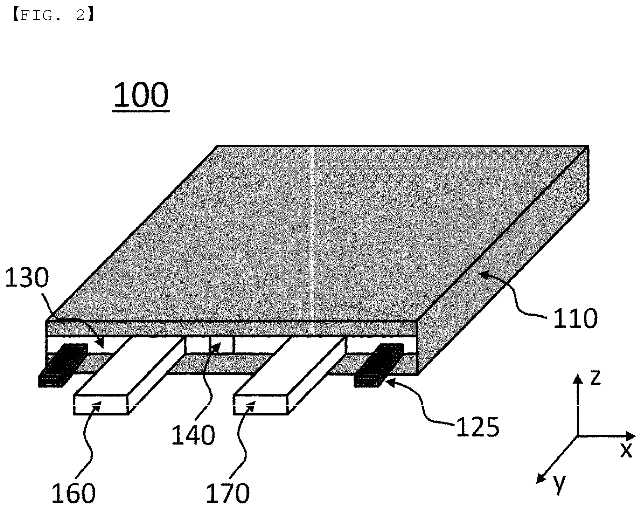

FIG. 2 is a perspective view of a pouch-shaped battery 100 according to an embodiment of the present invention.

Positive and negative electrode leads 160 and 170 protrude from one side surface of the pouch-shaped battery 100. A reflective film 140 is added to the one side surface of the pouch-shaped battery. The reflective film 140 is disposed halfway between the positive and negative electrode leads 160 and 170. However, the reflective film 140 may be disposed at the left side or the right side of the one side surface of the pouch-shaped battery, as needed. It is preferable for the reflective film 140 to be a visible light reflective film or an infrared reflective film. If a battery swells, the temperature of the battery increases in many cases. However, it may not be possible to definitely determine whether the infrared reflective film is damaged. In this case, therefore, it is preferable to use a visible light reflective film or an ultraviolet reflective film.

In the case in which the electrode leads 160 and 170 are not disposed at one side surface of the pouch-shaped battery but are disposed at different surfaces of the pouch-shaped battery, the reflective film 140 may be disposed at one surface or opposite surfaces of the pouch-shaped battery, as needed.

In order to sense swelling of the pouch-shaped battery, it is preferable for the reflective film 140 to lack elasticity. In the case in which the pouch-shaped battery swells, the inelastic reflective film must be torn or cut. It is preferable that the reflective film be made of a material that has no danger of fire even in the case in which the temperature of a battery cell is high while being capable of being easily damaged by tensile strength, such as film or paper. The surface of the material may be coated with a reflective material so as to be usable as the reflective film.

The surface of the pouch-shaped battery 100 is wrapped by a heat shrinkable film 110. A conductive film 120 is further added between the heat shrinkable film 110 and the pouch-shaped battery 100. The conductive film 120 has a protrusion 125 formed on one side surface of the pouch-shaped battery, from which the electrode leads 160 and 170 protrude. The protrusion 125, which is configured to conduct heat from the conductive film 120, protrudes outwards from the pouch-shaped battery 100 and is disposed in contact with a cooling portion 210, a description of which will follow, in order to conduct heat from the conductive film 120.

In the embodiment of the present invention, the reflective film 140 is separately added. Alternatively, the reflective film may be separately attached to the outermost contour of one side surface of the pouch-shaped battery, or a part of the heat shrinkable film or the conductive film may be further extended so as to be used as the reflective film.

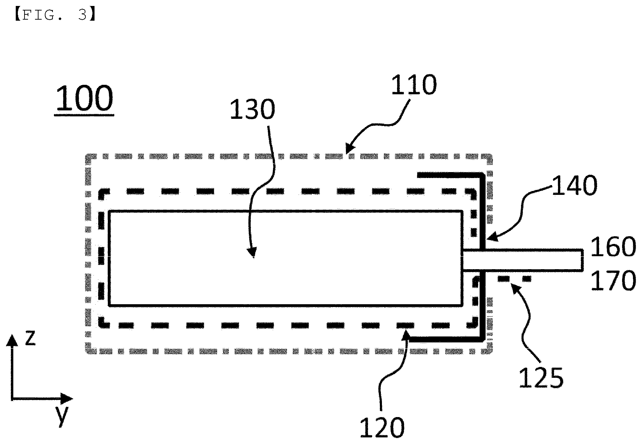

FIG. 3 is a side sectional view of the pouch-shaped battery 100 according to the embodiment of the present invention. The outermost contour of the pouch-shaped battery 100 is wrapped by the heat shrinkable film 110 (indicated by a double chain line). The conductive film 120 (indicated by a dotted line) is further added between the heat shrinkable film 110 and the pouch-shaped battery 100. The conductive film 120 has a protrusion 125 formed on one side surface of the pouch-shaped battery, from which the electrode leads 160 and 170 protrude. In FIG. 3, an electrode assembly 130 is shown but a case of the pouch-shaped battery 100 including the electrode assembly 130 is not shown. All of the heat shrinkable film, the conductive film, and the reflective film according to the present invention are disposed outside the case of the pouch-shaped battery.

In FIG. 3, the reflective film 140 is shown as being disposed between the heat shrinkable film 110 and the conductive film 120. Alternatively, the reflective film may be disposed at the contour of the heat shrinkable film 110 or in the conductive film 120. However, one side surface of the reflective film 140 must be open outside in order to reflect light irradiated by a light irradiation portion 224 of a swelling sensing unit 220, a description of which will follow.

The reflective film of FIG. 3 is disposed so as to extend to the upper end and the lower end of the pouch-shaped battery over one side surface of the pouch-shaped battery, at which the electrode leads 160 and 170 are disposed. The reason for this is that, when the battery swells, a change in length of the one side surface of the pouch-shaped battery, at which the electrode leads 160 and 170 are disposed, is not great and expansion of a planar portion of the pouch-shaped battery (a y-axis surface of the pouch-shaped battery in FIG. 3) is greater, and therefore it is more advantageous to sense expansion of the portion. At this time, only the end of the reflective film 140 on the planar portion (the y-axis surface of the pouch-shaped battery in FIG. 3) is fixed to the battery and a partial incision portion 145, a description of which will follow, is not fixed to the battery such that, when the battery swells, the partial incision portion 145 is cut, whereby the swelling sensing unit is capable of easily sensing swelling of the battery.

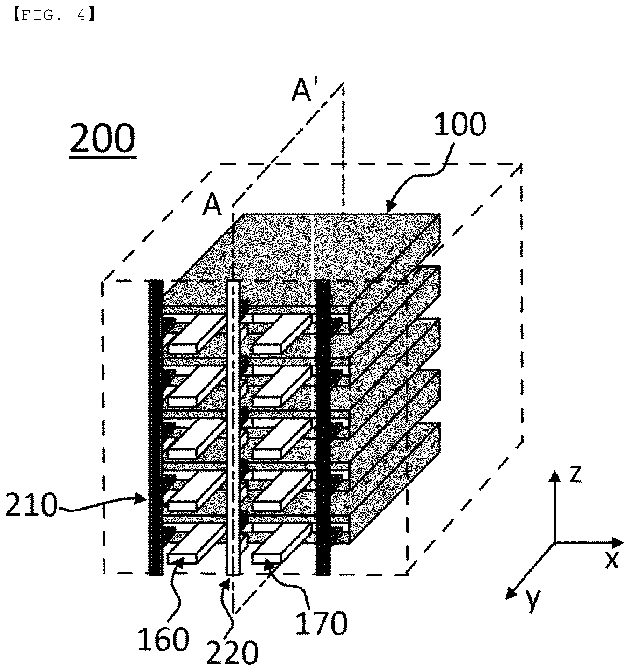

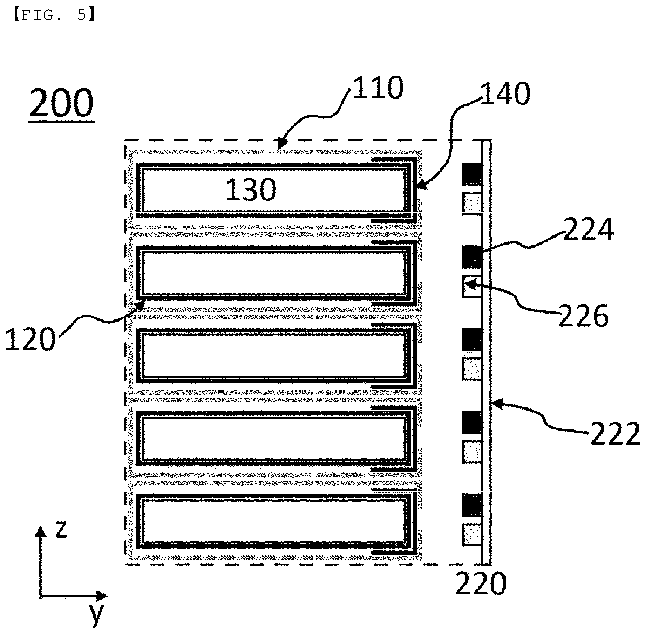

FIG. 4 is a perspective view of a battery pack 200 according to an embodiment of the present invention, and FIG. 5 is an AA' sectional view of the battery pack according to the embodiment of the present invention.

The battery pack 200 has at least one pouch-shaped battery 100 disposed therein. Concrete disposition of the batteries may be changed by those skilled in the art, and therefore a description thereof will be omitted. In FIG. 4, five pouch-shaped batteries 100 are disposed, and protrusions 125 abut a cooling portion 210 configured to lower temperature. The cooling portion 210, which is made of a high thermal conductivity material or is formed so as to have the shape of a pipe having a thermally conductive fluid flowing therein, is connected to a heat dissipation fin or a cooling portion configured to cool the battery pack or is connected to a means configured to dissipate heat through a battery module including a plurality of battery packs coupled to each other or a separate external device.

A swelling sensing unit 220 configured to detect whether reflective films are damaged is provided at the middle of a side center portion (an xz plane) of the pack. The swelling sensing unit 220 includes a plurality of pairs of light irradiation portions 224 and sensors 226 disposed along a sensor support portion 222.

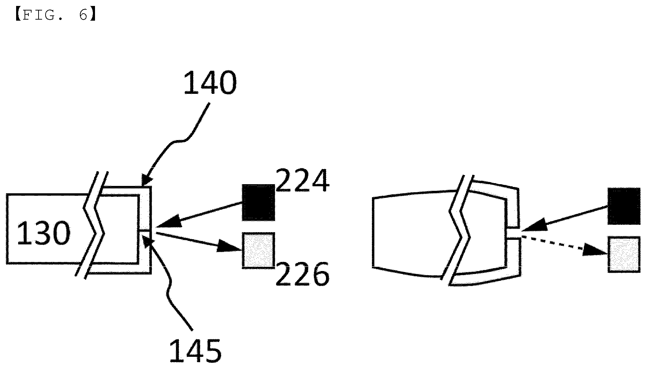

FIG. 6 is a schematic view showing a swelling sensing method according to an embodiment of the present invention.

The method of sensing swelling of the pouch-shaped batteries in the battery pack according to the present invention includes:
a) a step of the light irradiation portion 224 irradiating the reflective film 140 of a target pouch-shaped battery with light;
b) a step of the sensor 226 sensing light reflected by the reflective film 140; and
c) a step of determining that the target pouch-shaped battery has swelled in the case in which the sensor 226 does not sense light reflected by the reflective film 140.

When the pouch-shaped battery 100 expands due to swelling (see the right part of FIG. 6), whereby the reflective film 140 is torn, and therefore light reflected by the reflective film 140 is not sensed, it is determined that the pouch-shaped battery has swelled. It is preferable that, when the battery swells, a partial incision portion 145 be provided in the reflective film 140 such that a specific region of the reflective film 140 is easily damaged, whereby the specific region is easily cut.

Although the specific details of the present invention have been described in detail, those skilled in the art will appreciate that the detailed description thereof discloses only preferred embodiments of the present invention, while the scope of protection is defined in the appended claim.

### (Description of Reference Numerals)

10, 100: Pouch-shaped batteries
20: Battery case
30, 130: Electrode assemblies
40, 50: Electrode tabs
60, 70, 160, 170: Electrode leads
80: Insulative film
110: Heat shrinkable film
120: Conductive film
125: Protrusion
140: Reflective film
145: Partial incision portion
200: Battery pack
210: Cooling portion
220: Swelling sensing unit
222: Sensor support portion
224: Light irradiation portion
226: Sensor

### [Industrial Applicability]

As is apparent from the above description, the present invention has effects in that 1) no large space is occupied, 2) it is possible to easily sense overall swelling of a pouch-battery cell in a battery pack, whereby it is possible to determine whether the battery (cell) is abnormal, and 3) in the case in which pouch-battery cells are stacked in the battery pack, it is possible to efficiently transfer heat generated therein to the outside.

## Claims

1. A pouch-shaped battery (100) having a lead (160, 170) protruding from at least one side surface thereof, wherein a reflective film (140) is added to the one side surface, from which the lead (160, 170) protrudes.

2. The pouch-shaped battery (100) according to claim 1, wherein the reflective film (140) is a visible light reflective film.

3. The pouch-shaped battery (100) according to claim 1, wherein a heat shrinkable film (110) is added so as to wrap a surface of the pouch-shaped battery (100).

4. The pouch-shaped battery (100) according to claim 3, wherein a conductive film (120) is added between the heat shrinkable film (110) and the pouch-shaped battery (100).

5. The pouch-shaped battery (100) according to claim 4, wherein the conductive film (120) comprises at least one protrusion (125) formed on the one side surface, from which the lead (160, 170) protrudes.

6. The pouch-shaped battery (100) according to claim 4, wherein the heat shrinkable film (110) or the conductive film (120) is integrated with the reflective film (140).

7. A battery pack (200) comprising at least one pouch-shaped battery (100) according to any one of claims 1 to 6, wherein the battery pack (200) has a swelling sensing unit (220) added thereto, the swelling sensing unit comprising a light irradiation portion (224) and a sensor (226) configured to sense tear or cutting of the reflective film (140).

8. The battery pack (200) according to claim 7, further comprising at least one cooling portion (210) disposed in contact with the protrusion (125).

9. A method of sensing swelling of the pouch-shaped battery (100) in the battery pack (200) according to claim 7, the method comprising:
a) irradiating, by the light irradiation portion (224), the reflective film (140) of a target pouch-shaped battery (100) with light;
b) sensing, by the sensor (226), light reflected by the reflective film (140); and
c) determining that the target pouch-shaped battery (100) has swelled in a case in which the sensor (226) does not sense light reflected by the reflective film (140).

10. The method according to claim 9, wherein, when the pouch-shaped battery (100) expands due to swelling, whereby the reflective film (140) is torn, and therefore light reflected by the reflective film (140) is not sensed, the pouch-shaped battery (100) is determined to have swelled.

11. The method according to claim 9, wherein the pouch-shaped battery (100) is disposed in the battery pack (200), and
wherein the light irradiation portion (224) and the sensor (226) are disposed at a side surface of the battery pack (200).

## Patentansprüche

1. Beutelförmige Batterie (100), welche eine Leitung (160, 170) aufweist, welche von wenigstens einer Seitenfläche davon vorsteht, wobei eine reflektierende Schicht (140) zu der einen Seitenfläche hinzugefügt ist, von welcher die Leitung (160, 170) vorsteht.

2. Beutelförmige Batterie (100) nach Anspruch 1, wobei die reflektierende Schicht (140) eine sichtbares Licht-reflektierende Schicht ist.

3. Beutelförmige Batterie (100) nach Anspruch 1, wobei eine wärmeschrumpfende Schicht (110) derart hinzugefügt ist, dass eine Fläche der beutelförmigen Batterie (100) eingewickelt ist.

4. Beutelförmige Batterie (100) nach Anspruch 3, wobei eine leitfähige Schicht (120) zwischen der wärmeschrumpfenden Schicht (110) und der beutelförmigen Batterie (100) hinzugefügt ist.

5. Beutelförmige Batterie (100) nach Anspruch 4, wobei die leitfähige Schicht (120) wenigstens einen Vorsprung (125) umfasst, welcher an der einen Seitenfläche ausgebildet ist, welche von der Leitung (160, 170) vorsteht.

6. Beutelförmige Batterie (100) nach Anspruch 4, wobei die wärmeschrumpfende Schicht (110) oder die leitfähige Schicht (120) mit der reflektierenden Schicht (140) integriert ist.

7. Batteriepack (200), umfassend wenigsten eine beutelförmige Batterie (100) nach einem der Ansprüche 1 bis 6, wobei der Batteriepack (200) eine Schwellungsmesseinheit (220) aufweist, welche dazu hinzugefügt ist, wobei die Schwellungsmesseinheit einen Lichtbestrahlungsabschnitt (224) und einen Sensor (226) aufweist, welche dazu eingerichtet sind, ein Reißen oder ein Trennen der reflektierenden Schicht (140) zu messen.

8. Batteriepack (200) nach Anspruch 7, ferner umfassend wenigstens einen Kühlabschnitt (210), welcher in Kontakt mit dem Vorsprung (125) angeordnet ist.

9. Verfahren eines Messens einer Schwellung der beutelförmigen Batterie (100) in einem Batteriepack (200) nach Anspruch 7, wobei das Verfahren umfasst:
a) Bestrahlen, durch den Lichtbestrahlungsabschnitt (224), der reflektierenden Schicht (140) einer beutelförmigen Zielbatterie (100) mit Licht;
b) Messen, durch den Sensor (226), von Licht, welches durch die reflektierende Schicht (140) reflektiert wird; und
c) Bestimmen, dass die beutelförmigen Zielbatterie (100) geschwollen ist, in einem Fall, in welchem der Sensor (226) Licht nicht misst, welches durch die reflektierende Schicht (140) reflektiert wird.

10. Verfahren nach Anspruch 9, wobei, wenn sich die beutelförmige Batterie (100) aufgrund einer Schwellung ausdehnt, wodurch die reflektierende Schicht (140) aufgerissen wird, und dadurch Licht, welches durch die reflektierende Schicht (140) reflektiert wird, nicht gemessen wird, bestimmt wird, dass die beutelförmige Batterie (100) geschwollen ist.

11. Verfahren nach Anspruch 9, wobei die beutelförmige Batterie (100) in dem Batteriepack (200) angeordnet ist, und
wobei der Lichtbestrahlungsabschnitt (224) und der Sensor (226) an einer Seitenfläche des Batteriepacks (200) angeordnet sind.

## Revendications

1. Batterie en forme de poche (100) ayant un fil (160, 170) faisant saillie à partir d'au moins une surface latérale de celle-ci, dans laquelle un film réfléchissant (140) est ajouté à l'une surface latérale, à partir de laquelle le fil (160, 170) fait saillie.

2. Batterie en forme de poche (100) selon la revendication 1, dans laquelle le film réfléchissant (140) est un film réfléchissant la lumière visible.

3. Batterie en forme de poche (100) selon la revendication 1, dans laquelle un film thermorétractable (110) est ajouté de façon à envelopper une surface de la batterie en forme de poche (100).

4. Batterie en forme de poche (100) selon la revendication 3, dans laquelle un film conducteur (120) est ajouté entre le film thermorétractable (110) et la batterie en forme de poche (100).

5. Batterie en forme de poche (100) selon la revendication 4, dans laquelle le film conducteur (120) comprend au moins une saillie (125) formée sur l'une surface latérale, à partir de laquelle le fil (160, 170) fait saillie.

6. Batterie en forme de poche (100) selon la revendication 4, dans laquelle le film thermorétractable (110) ou le film conducteur (120) est intégré au film réfléchissant (140).

7. Bloc-batterie (200) comprenant au moins une batterie en forme de poche (100) selon l'une quelconque des revendications 1 à 6, dans lequel le bloc-batterie (200) a une unité de détection de gonflement (220) ajoutée à celui-ci, l'unité de détection de gonflement comprenant une partie d'exposition à la lumière (224) et un capteur (226) configuré pour détecter une déchirure ou une rupture du film réfléchissant (140).

8. Bloc-batterie (200) selon la revendication 7, comprenant en outre au moins une partie de refroidissement (210) disposée en contact avec la saillie (125).

9. Procédé de détection d'un gonflement de la batterie en forme de poche (100) dans le bloc-batterie (200) selon la revendication 7, le procédé comprenant :
a) l'exposition, par la partie d'exposition à la lumière (224), du film réfléchissant (140) d'une batterie en forme de poche (100) cible à la lumière ;
b) la détection, par le capteur (226), de la lumière réfléchie par le film réfléchissant (140) ; et
c) le fait de déterminer que la batterie en forme de poche (100) cible a gonflé dans un cas où le capteur (226) ne détecte pas la lumière réfléchie par le film réfléchissant (140).

10. Procédé selon la revendication 9, dans lequel, lorsque la batterie en forme de poche (100) se dilate en raison d'un gonflement, moyennant quoi le film réfléchissant (140) se déchire, et donc la lumière réfléchie par le film réfléchissant (140) n'est pas détectée, il est déterminé que la batterie en forme de poche (100) a gonflé.

11. Procédé selon la revendication 9, dans lequel la batterie en forme de poche (100) est disposée dans le bloc-batterie (200), et
dans lequel la partie d'exposition à la lumière (224) et le capteur (226) sont disposés au niveau d'une surface latérale du bloc-batterie (200).
